# EUROPEAN PATENT SPECIFICATION

(11) **EP 0 252 478 B1**
(45) Date of publication and mention of the grant of the patent: **06.10.1993**
(21) Application number: 87109731.7
(22) Date of filing: 06.07.1987
(51) Int. Cl.: C23C 14/34, C22F 1/10

(54) **Co-base alloy sputter target and process of manufacturing thereof**
Target aus Kobalt-Basis für Kathodenzerstäubung und Verfahren zu seiner Herstellung
Cible à base de cobalt pour dépôt par pulvérisation et procédé de sa fabrication

(30) Priority: 08.07.1986 JP 158755/86
(43) Date of publication of application: 13.01.1988
(73) Proprietor: NIHON SHINKU GIJUTSU KABUSHIKI KAISHA, Chigasaki-shi Kanagawa-ken (JP)
(72) Inventor: Nakamura, Kyuzo, Inba-gun Chiba-ken (JP); Ota, Yoshifumi, Inba-gun Chiba-ken (JP); Yamada, Taiki, Narita-shi Chiba-ken (JP); Ishikawa, Michio, Inba-gun Chiba-ken (JP); Tani, Noriaki Umenosato-Ryo, Inba-gun Chiba-ken (JP); Higuchi, Yasushi Umenosato-Ryo, Inba-gun Chiba-ken (JP)
(74) Representative: Schmidt-Evers, Jürgen, Dipl.-Ing.

(56) References cited:
- EP-A- 0 054 269
- US-A- 3 494 807
- US-A- 3 626 570
- US-A- 4 414 087
- ZEITSCHRIFT FÜR METALLKUNDE, vol. 75, no. 11, November 1984, pages 847-854, Stuttgart, DE; J.A. THORNTON: "Hollow cathode magnetron sputtering of metallurgical coatings"
- PATENT ABSTRACTS OF JAPAN, vol. 9, no. 121 (M-382)[1844], 25th May 1985; & JP-A-60 6219 (MITSUI KINZOKU KOGYO K.K.) 12-01-1985

## Description

This invention relates to a Co-base alloy target adaptable for magnetron sputtering, and a process for its manufacture.

A conventional Co-base alloy sputter target hitherto used comprises partially an h.c.p. phase and the remainder an f.c.c. phase and an h.c.p. phase, and is manufactured by such a process that a Co-base alloy material comprising an f.c.c. single phase is heated to be melted, and is then poured into a mould and is cooled from a high temperature, at which it comprises the f.c.c. single-phase, by such a manner that the resultant molded one is stood to be cooled or that after the molded one is subjected to a hot-working treatment the same is stood to be cooled, so that part of the f.c.c. single phase is transformed into a Martensite comprising an h.c.p. phase, and the Co-base alloy thus manufactured has been used for a magnetron sputtering so far. A suitable Co-based alloy is known from US-A-3 626 570.

The magnetron sputtering is carried out by such a manner that there is created a leakage magnetic field on and over the surface of the target so that plasma may be concentrated on the surface of the target. In the case of using as a target such a magnetic substance as the conventional Co-base alloy manufactured as above, the magnetic flux is easy to pass through the interior of the target. It has been necessary, for forming the leakage field on the surface of the target, that the thickness of the target is made thin while saturation magnetization thereof is being taken into consideration.

The conventional Co-base alloy sputter target as mentioned above is thin in thickness and consequently there is involved such defects that a service life is comparatively short, and that according to the progress of erosion thereof the magnetic field in the eroded recessed portion is increased, so that the plasma is concentrated onto the eroded portion, and thus the target is locally consumed to result in a poor utilization factor.

Accordingly, it is desirable to make it possible to use a Co-base alloy sputter target which is thicker than the conventional Co-base alloy sputter target.

The inventors, in order to meet the above desire, have made various studies and researches about relations of the magnetic property of the Co-base alloy sputter target with the surface leakage magnetic field or the erosion shapes or others. As a result thereof, there has been obtained such unexpected findings that there is no fact of such a conventional thought that the generation of the surface leakage field depends on the target material, the fact is such that the same depends on a permeability thereof. And basing on the findings, it has been confirmed that even with a Co-base alloy which is large in saturation magnetization, the permeability thereof can be smaller and thereby the surface leakage magnetic field can be strengthened. Also it has been found that, in the case of the Co-base alloy, the amount ratio of the f.c.c. phase and the h.c.p. phase has mostly influence on the magnitude of the permeability. Namely, it has been found that the h.c.p. phase of the Co-base alloy is very large in crystal magnetic anisotropy, whereas the f.c.c. phase thereof is small in crystal magnetic anisotropy, and consequently if the amount of h.c.p. phase is increased, the permeability of the Co-base alloy is decreased, and the generation of the leakage magnetic field on the surface of the target becomes easier. Further, it has been found that if an addition amount of such an element as Ni, Cr, Pt, W, V, Ti or the like to be added in the Co-base metal, is increased, the permeability of the Co-base alloy is decreased and accordingly the leakage magnetic field thereof becomes easier by that amount, in spite of that the saturation magnetization is decreased.

From the point of view of the amount ratio of the f.c.c. phase to the h.c.p. phase, if it is possible that the f.c.c. phase of the Co-base alloy sputter target manufactured by the conventional process is decreased, and the h.c.p. phase thereof is increased so that the value of the amount ratio to the f.c.c. phase to the h.c.p. phase may become small, the permeability of the target could be decreased by that decreased value and, resulting in increase in generation of the leakage magnetic field on the surface of the target. This means that there could be used a Co-base alloy which is thicker than the conventional Co-base alloy, resulting in prolongation of the service life and improvement in the utilization efficiency. Also, accordingly, if the Co-base alloy with a smaller amount ratio of the f.c.c. phase to the h.c.p. phase is used in such a condition that the thickness thereof is equal to that of the conventional one, there would be brought about reduction in the size of a magnetic generation apparatus and saving of a consumption of an electric power.

By the way, it is difficult to obtain the amount ratio of the f.c.c. phase to the h.c.p. phase of the Co-base alloy in terms of an amount ratio by volume. Accordingly, it can be considered to obtain an X-ray diffraction peak intensity ratio which is proportional to the volumetric amount ratio. In this case, X-ray diffraction peaks in respect with the f.c.c. phase and X-ray diffraction peaks in respect with the h.c.p. phase are overlapped with each other in faces thereof, but there is the fact that an X-ray diffraction peak in a (200) face in the f.c.c. phase and an X-ray diffraction peak in a (101) face in the h.c.p. phase are not overlapped with each other. Therefore, an X-ray diffraction peak intensity ratio, that is, I_{fcc(200)}/I_{hcp(101)} are measured by using this fact, and thereby the mixing ratio of the two phases can be obtained as a relative value.

The inventors have developed a process of manufacturing a Co-base alloy sputter target which is smaller, in the X-ray diffraction peak intensity ratio of the f.c.c. phase to the h.c.p. phase, than the conventional Co-base alloy sputter target manufactured by the foregoing conventional process. Namely, a purpose of this invention is to provide a process of manufacturing a Co-base alloy sputter target in which, in the first place, a conventional Co-base alloy is manufactured by such a process that a Co-base alloy material comprising an f.c.c. single phase is heated to be melted and is then poured into a mould and is cooled from a high temperature at which it comprises the f.c.c. phase in such a cooling manner that the resultant molded one is stood to be cooled to a normal temperature or that after the molded one is subjected to a hot-working treatment the same is stood to be cooled to a normal temperature, so that part of the f.c.c. single phase is transformed into a Martensite comprising an h.c.p. phase, and, in the second place, the resultant Co-base alloy comprising the h.c.p. phase and the f.c.c. phase is subjected to a cold-working treatment and thereby a compression strain may be given thereto, and addtionally, part of the f.c.c. phase still remaining unchanged into an h.c.p. phase may be transformed into a Martensite comprising the h.c.p. phase.

Thus, there is obtained this invention Co-base alloy sputter target in which a value of an X-ray diffraction peak intensity ratio, I_{fcc(200)}/I_{hcp(101)} is smaller than that of an X-ray diffraction peak intensity ratio of the foregoing convention Co-base alloy not yet subjected to the cold-working treatment. Thus, accordingly, this invention is to provide the Co-base alloy sputter target of which the permeability is decreased according to the smaller value of the X-ray diffraction peak intensity ratio, I_{fcc(200)}/I_{hcp(101)}. Thus, the foregoing defects with the conventional Co-base alloy sputter target can be removed by the foregoing improved Co-base alloy sputter target of this invention, and there can be used this invention Co-base alloy sputter target which is thicker than the conventional one, and in the case of using such a thicker one the service life is longer and the utilization efficiency is improved as compared with the conventional one. Namely, the amount ratio of the f.c.c. phase to the h.c.p. phase of this invention is smaller than the conventional one, and according to the smaller value the permeability thereof becomes lower, and accordingly generation of the surface leakage magnetic field can be obtained more easily, so tht the sputter target can be made thicker, and accordingly the utilization efficiency can be increased by that amount.

As for the cold-working means, there can be used any desired one selected from the conventional ones such as rolling, drawing, swaging, forging, general press working or the like. In this case, it is preferable that the Co-base alloy is cold-worked so that a compression ratio thereof may become about 5 % or more.

Next, embodying examples of this invention will be explained together with comparison examples and with relation to the drawings in which
Fig. 1 is a graph showing the relations between an X-ray diffraction peak intensity ratio, I_{fcc(200)}/I_{hcp(101)}, of a Co-base alloy sputter target and a thickness thereof,
Fig. 2 is a graph showing the relations between the intensity ratio therof and a utilization efficiency thereof, and,
Fig. 3 is a graph showing the relations between the intensity ratio thereof and a cross-sectional area compression ratio thereof.

As for Co-base alloy material, there can be used any desired one selected from all kinds of Co-base alloy materials having various compositions prepared respectively by using a Co metal as a base material and mixing therein at least one kind of additive metals such as Ni, Cr. Pt, W, etc. According to the process the selected one having any desired composition and comprising an f.c.c. single-phase is heated to a high temperature to be melted, and the melted is poured into a predetermined mould to be cooled to a normal temperature. Or before cooling the melted one to a normal temperature, the solidified one which is still in a hot condition is subjected to a hot-working treatment to be pressed into a sheet of predetermined width, and the resultant sheet is cooled to a normal temperature. In any case, in the course of cooling thereof, part of the f.c.c. phase thereof is transformed into an h.c.p. phase, that is, a Martensite. The resultant Co-base alloy comprising the h.c.p. phase and the f.c.c. phase is a conventional product. In the following Table 1, there are shown the conventional Co-sputter target products manufactured by the foregoing process, which are a sample No.1 comprising Co-20at.%Ni-10at.%Cr, a sample No.5 comprising Co-16at.%Cr, a sample No.7 comprising Co-20at.%Ni-10at.%Pt, and a sample No.9 comprising Co-25at.%Ni. The respective values of X-ray diffraction peak intensity ratio, I_{fcc(200)}/I_{hcp(101)}, were 1.75, 1.90, 1.65 and 2.03.

According to this invention, the foregoing respective conventional Co-base alloys were subjected to a cold-rolling treatment. By the cold-working treatment, those samples were compressed so that the respective sectional area compression ratios thereof may become 5 % or more as shown in Table 1. As a result, there were obtained the cold-worked Co-base alloy sputter target products of this invention indicated as respective samples No.2, 3, 4, 6, 8 and 10 shown in Table 1. When the respective samples are compared with the foregoing conventional samples in respective of the X-ray diffraction peak intensity ratio, I_{fcc(200)}/I_{hcp(101)}, it can be understood therefrom that the intensity ratio value 1.75 with (the conventional product sample No. 1) was lowered to 1.21 with the intensity ratio of the cold-worked this invention product (Sample No.2) under the condition of the 5 % sectional area compression ratio, and, further, recording to increasing the sectional area compression ratio to 10 %, 15 %, the intensity ratio was lowered to 0.39, 0.30, respectively, (Sample No.3 and Sample No.4), and also in respect of the respective intensity ratios of the samples No.5, No.7 and No.9, the respective values thereof were lowered by being subjected to the cold-working treatment. Namely, the value, 1.90 (Sample No.5) was lowered to 0.45 (Sample No.6), 1.65 (Sample No.7) to 0.35 (Sample No.8) and 2.03 (Sample No.9) to 0.42 (Sample No.10). Thus, it has been confirmed that the X-ray diffraction peak ratio of the (200)_{fcc}/the (101)_{hcp} of the convention Co-base alloy product is lowered by applying the cold-working to the product, and also according as the compression ratio of this invention product by the cold-working is increased the value of the intensity ratio is lowered.

Measuring of the intensity ratio and that of the permeability of each of the foregoing samples were carried out on such slices of those samples that had been treated with aqua regia.

The measured results of the permeabilities of those samples were also as shown in Table 1. It has been confirmed therefrom that the permeabilities of the conventional product samples can be also lowered remarkably by the cold-working treatment.

Next, respective target properties of the respective samples were examined by using a D.C. magnetron cathode of dimensions of 127 mm x 203.2 mm (5 inches X 8 inches) to show the results thereof shown in Table 1. Here, the term "relative target thickness" represents a target thickness when there is generated on the surface thereof a leakage magnetic field of 250 G under such a conditiion that each sample of target is placed on the cathode in which there exists a parallel magnetic field of 600 G at the center between the magnetic poles.

As clear from the values of the relative thicknesses of the respective samples as shown in Table 1, the respective Co-base alloy target samples which were cold-worked according to this invention can be made remarkably thicker than the corresponding respective conventional Co-base alloy target samples which were not cold-worked, that is, before subjected to the cold-working. Further, for the respective target samples, respective target utilization efficiencies thereof were examined in such a manner that each of the target samples 5 mm thick each was set in position as a target and a cathode was adjusted so that a surface leakage magnetic field may become 250 G, and under the condition, a sputtering process was then carried out and during the sputtering operation the plasma used is concentrated on the cavity of the eroded area of the target and thus the target was locally erosed and at last when the thickness of the maximum eroded part thereof becomes zero "0", the sputtering process is stopped, and the utilized amount of the target was measured. The results thereof were as shown in Table 1. It can be appreciated therefrom that the utilization efficiencies of the cold-worked targets of this invention were remarkably improved as compared with the targets not treated with the cold-work treatments.

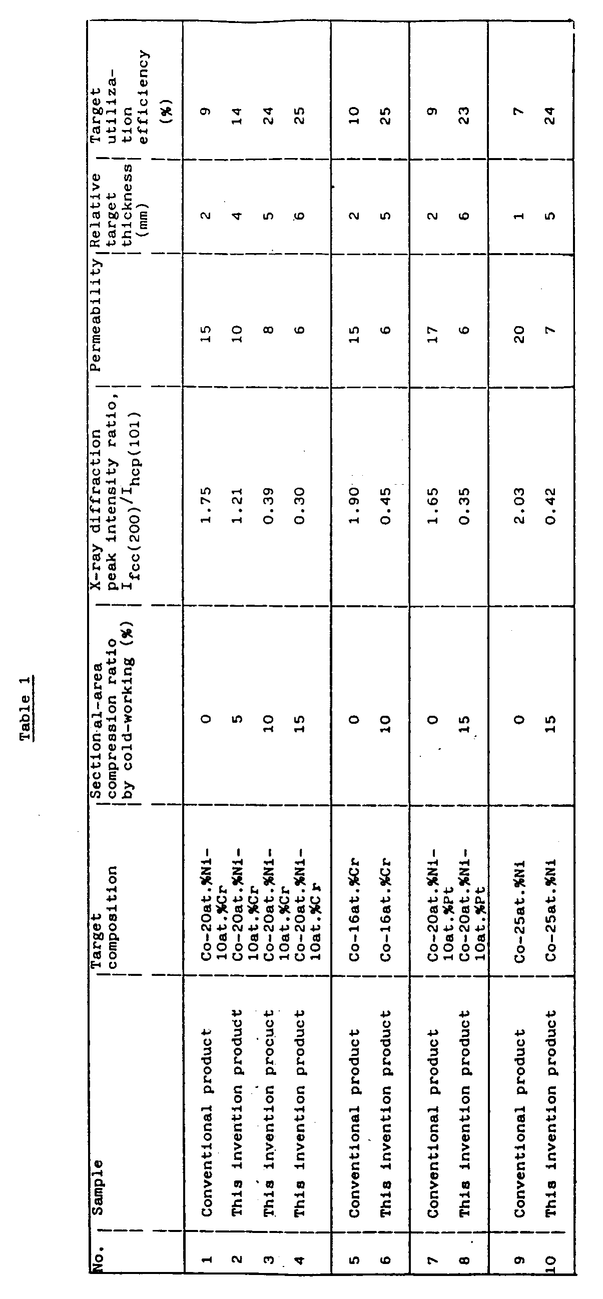

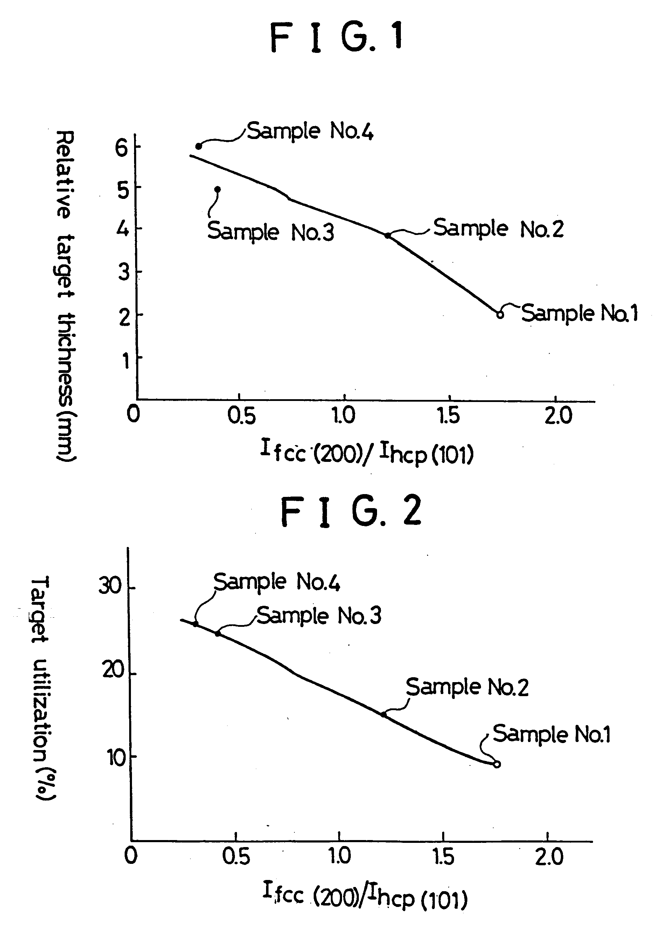

Fig. 1 and Fig. 2 show the relation of the X-ray diffraction peak intensity ratio I_{fcc(200)}/I_{hcp(101)} with the relative target thickness and the relation thereof with the target utilization efficiency, respectively, in the case of taking the target comprising Co-20at.%Ni-10at.%Cr for a typical example, and it can appreciated therefrom that the target thickness and the target utilization efficiency, respectively become larger according as the intensity ratio become smaller.

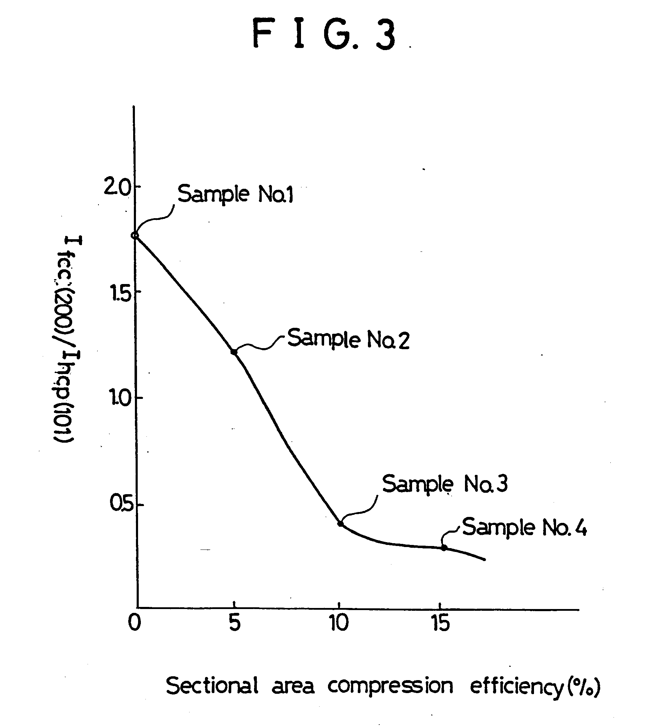

Fig. 3 shows the relation of the X-ray diffraction peak intensity ratio, I_{fcc(200)}/I_{hcp(101)} and, the target sectional-area compression ratio in the case of taking the target comprising Co-20at.%Ni-10at.%Cr for a typical example, and it can be appreciated therefrom that the intensity ratio becomes lower accordingly as the compression ratio becomes larger.

Further, the foregoing embodying examples have been explained about the case of using the D. C. magnetron sputtering, but this invention can be adapted to any desired sputtering process of the type controlling the plasma by using a magnetic field of an R. F. magnetron, an coaxial magnetron, triode magnetron or the like.

According to this invention, in the first place, Co-base alloy material comprises a f.c.c. single-phase is melted by heating and is then cooled from a high temperature to a normal temperature so that part thereof may be transformed into a h.c.p. phase, that is, so that a Martensite transformation may take place, and thereafter the resultant one is cold-worked so as to be given a compression strain, so that a value of X-ray diffraction peak intensity ratio of I_{fcc(200)}/I_{hcp(101)} thereof is lowered, and thus the resultant cold-worked Co-base alloy of this invention is obtained. If the product is used for a sputter target, a surface leakage magnetic field thereof can be generatied easily even by using the same of which the thickness is thicker than that of the conventional Co-base alloy not yet cold-worked, and also a utilization efficiency thereof can be increased, and in the case where the thickness thereof is equal to that of the one not yet cold-worked, a magnetic generation apparatus can be small-sized and also a consumption amount of electric power can be decreased as desired, as an occasion demands.

## Claims

1. A Co-based alloy sputter target comprising an f.c.c. phase and an h.c.p. phase, characterized in that a valve of an intensity ratio of an f.c.c. (200) peak to an h.c.p. (101) peak of an X-ray diffraction of the sputter target, that is, an X-ray diffraction peak ratio I_{fcc(200)}/I_{hcp(101)} thereof, is smaller than that of the X-ray diffraction peak ratio I_{fcc(200)}/I_{hcp(101)} of a reference Co-based alloy comprising an f.c.c. single phase at a high temperature of manufacturing thereof and having the same composition as that of the sputter target, said reference Co-based alloy having been cooled from said high temperature to room temperature.

2. A process of manufacturing a Co-based alloy sputter target characterized in that a Co-based alloy comprising an f.c.c. single phase at a high temperature of manufacturing thereof and cooled from the high temperature to a room temperature so that there takes place a Martensite transformation is subjected to a cold-working treatment such that a value of an intensity ratio of an f.c.c. (200) peak to an h.c.p. (101) peak of an X-ray diffraction of the Co-based alloy after the cold-working treatment, that is, an X-ray diffraction peak ratio I_{fcc(200)}/I_{hcp(101)} thereof, is smaller than that of the X-ray diffraction peak ratio I_{fcc(200)}/I_{hcp(101)} of the Co-based alloy when the Co-based alloy is cooled from the f.c.c. phase at the high temperature to room temperature.

## Patentansprüche

1. Sputter-Target einer legierung auf Kobaltbasis, die eine fcc-Phase und eine hcp-Phase aufweist, dadurch gekennzeichnet, daß ein Verhältnis der Intensitäten des fcc-(200)-Peaks und des hcp-(101)-Peaks der Röntgenstreuung des Sputter-Targets, d. h. ein Intensitätsverhältnis I_{fcc(200)}/I_{hcp(101)} der Röntgenstreu-Peaks Kleiner ist als das Intensitätsverhältnis I_{fcc(200)}/I_{hcp(101)} der Röntgenstreu-Peaks einer Referenzlegierung auf Kobaltbasis, die bei hoher Temperatur bei der Herstellung eine einzige fcc-Phase besitzt und die dieselbe Zusammensetzung wie das Sputter-Target aufweist, und welche Referenzlegierung auf Kobaltbasis von dieser hohen Temperatur auf Raumtemperatur abegekühlt worden ist.

2. Verfahren zur Herstellung eines Sputter-Targets einer Legierung auf Kobaltbasis, dadurch gekennzeichnet, daß eine Legierung auf Kobaltbasis, die bei einer hohen Temperatur bei der Herstellung eine einzige fcc-Phase besitzt und von dieser hohen Temperatur auf Raumtemperatur abgekühlt wird, so daß eine Martensit-Umwandlung stattfindet, einem Kaltbearbeitungsschritt unterworfen wird, derart, daß ein Verhältnis der Intensitäten des fcc-(200)-Peaks und des hcp-(101)-Peaks der Röntgenstreuung der Legierung auf Kobaltbasis nach dem Kaltbearbeitungsschritt d. h. ein Intensitätsverhältnis I_{fcc(200)}/I_{hcp(101)} der Röntgenstreu-Peaks davon Kleiner ist als das Intensitätsverhältnis I_{fcc(200)}/I_{hcp(101)} der Röntgenstreu-Peaks der Legierung auf Kobaltbasis, wenn die Legierung auf Kobaltbasis von der fcc-Phase bei hohen Temperaturen auf Raumtemperatur abgekühlt wurde.

## Revendications

1. Cible à base de cobalt pour dépôt par pulvérisation, comprenant une phase f.c.c. et une phase h.c.p., caractérisée en ce que la valeur du rapport d'intensité d'un pic f.c.c. (200) à un pic h.c.p. (101) de la diffraction des rayons X de la cible pour dépôt par pulvérisation, c'est-à-dire, du rapport des pics de diffraction des rayons X I_{fcc(200)}/I_{hcp(101)} de celle-ci, est inférieure à celle du rapport des pics de diffraction des rayons X I_{fcc(200)}/I_{hcp(101)} d'un alliage de référence à base de cobalt, comprenant une phase unique f.c.c. à une température élevée de fabrication de celui-ci et ayant la même composition que celle de la cible pour dépôt par pulvérisation, ledit alliage de référence à base de cobalt ayant été refroidi à partir de ladite température élevée jusqu'à la température ambiante.

2. Procédé de fabrication d'une cible à base de cobalt pour dépôt par pulvérisation, caractérisé en ce qu'un alliage à base de cobalt, comprenant une phase unique f.c.c. à une température élevée de fabrication de celui-ci et refroidi à partir de la température élevée jusqu'à la température ambiante de telle sorte qu'une transformation en martensite ait lieu, est soumis à un traitement de formage à froid tel que la valeur du rapport d'intensité d'un pic f.c.c. (200) à un pic h.c.p. (101) de la diffraction des rayons X de l'alliage à base de cobalt après le traitement de formage à froid, c'est-à-dire, du rapport des pics de diffraction des rayons X I_{fcc(200)}/I_{hcp(101)} de celui-ci, est inférieure a celle du rapport des pics de diffraction des rayons X I_{fcc(200)}/I_{hcp(101)} de l'alliage à base de cobalt lorsque l'alliage à base de cobalt est refroidi à partir de la phase f.c.c. à la température élevée jusqu'à la température ambiante.
